# EUROPEAN PATENT APPLICATION

(11) **EP 0 969 402 A2**
(43) Date of publication of application: **05.01.2000**
(21) Application number: 99305127.5
(22) Date of filing: 29.06.1999
(51) Int. Cl.: G06K 7/00

(54) **Identification card processing system and method**

(30) Priority: 01.07.1998 JP 18626298
(71) Applicant: CANON KABUSHIKI KAISHA, Tokyo (JP)
(72) Inventor: Keiji, Tsuchiya, Ohta-ku, Tokyo (JP)
(74) Representative: Beresford, Keith Denis Lewis

(57) **Abstract**

An identification card processing system is provided for confirming the validity of an identification card by reading the information recorded on the card. The system includes a first processing apparatus 20, 21 able to access all the information recording regions on the card and several second processing apparatus 50 each able to access only part of the information recording regions on the card 1, the second apparatus being located at different locations to the first processing apparatus. The second processing apparatus 50 is used to access information in those regions of the card accessible to the second processing apparatus 50. The first apparatus 20, 21 is used when it is necessary to access information on the remaining regions of the card.

## Description

### BACKGROUND OF THE INVENTION

### Related art

This invention relates to an identification card processing system and method for confirming the validity of an identification card using information recorded on the card.

### Prior art

Magnetic cards, integrated circuit (IC) cards and optical cards are already used as identification cards. Optical cards in particular are expected to be in demand as identification cards because of their large memory capacity and the difficulty of falsifying information recorded on such cards.

Where an optical card is used as an identification card, there are a wide range of applications. The use of the card as a passport card will now be explained.

A passport card is used instead of a passport made of paper and is recorded with information such as the identity of the passport issuer and the identity of the passport owner. Such a passport card is issued by a passport issuing authority licensed by a government. The authority issues the passport card using an identification card issuing apparatus.

When a passport holder departs from a country, firstly the passport holder hands the identification card to an official at a passport control point. Next, the official inserts the card into an identification card processing apparatus to read out information such as the identity of the passport issuer and the identity of the passport owner from the card. Following this, the official will refer to the read out information to judge whether the identification is valid or not, and whether the identification card actually belongs to the passport holder or not. If the result of the judgment is that the identification is valid, the card is returned to the passport holder after the departure date and/or the time and place has been recorded on the card. The departure examination is thus complete.

When a passport holder enters into a country, firstly the passport holder hands the identification card to an official at an immigration counter (i.e. passport control). Next, the official inserts the card into an identification card processing apparatus. Information such as the identity of the passport issuer and the identity of the passport owner is read out from the card. Following this, the official refers to the read out information to judge whether the identification is valid or not and whether the card belongs to the passport holder or not. If the result of the judgment is that the identification is valid, the card is returned to the passport holder after the entry date and/or the time and place is recorded on the card. The immigration examination is thus complete.

The passport card issuing apparatus for issuing the passport card may be the same apparatus as the identification card processing apparatus used at passport control for reading the card. Identification card processing apparatus generally include a host computer and an optical card information reading and/or writing apparatus. Such an optical information reading and/or writing apparatus connected to a host computer is called a stationary type reading and/or writing apparatus.

When recording the information on the optical card using this stationary type optical information reading and/or writing apparatus, firstly the information is input into the host computer, and then the information is recorded on the optical card in response to a command from the host computer. When reproducing the information from the optical card, firstly the information is reproduced from the optical card in accordance with a command from the host computer, and then the reproduced information is displayed on the display of the host computer.

However, because the area provided for passport control is generally small, it is difficult to install the host computer and the stationary type optical information reading and/or writing apparatus, in the area provided for passport control. Even if it is possible to install the computer and the card reading and/or writing apparatus, a large space in passport control will be occupied by the computer and card reading/writing apparatus. Also, there is the problem that the installation of the host computer and the stationary type optical information card reading and/or writing apparatus at every passport control point is costly.

### SUMMARY OF THE INVENTION

It is an object of this invention to at least alleviate the above problems. In particular, an object is to supply an identification card processing system which may be installed in a relatively small area at a relatively low cost, and a method of use of such a system.

According to one aspect of the present invention, there is provided an identification card processing system for confirming the validity of an identification card using information recorded on the card, the apparatus comprising:
a first card reading apparatus enabling access to all the information recording regions on the card; and
a second card reading apparatus enabling access into only part of the information recording regions;
the apparatus being characterized in that information for identifying a card holder is accessed on the card by the second processing apparatus, and the validity of the card is checked on the basis of the information reproduced by the second card processing apparatus, the first card processing apparatus being used only when it is necessary to access further information.

The invention also provides a method of processing identification information recorded on an identification card.

### BRIEF DESCRIPTION OF THE DRAWINGS

An embodiment of the present invention will now be described, by way of example only, with reference to the accompanying drawings in which:
Fig. 1 illustrates the appearance of a portable type card reading/writing apparatus utilized in an identification card processing system in accordance with an embodiment of the present invention;
Fig. 2 illustrates the appearance of a host computer and a stationary type card reading/writing apparatus incorporated in the embodiment of the present invention;
Fig. 3 illustrates an example of an optical card for use in the identification card system of Figs. 1 and 2;
Fig. 4 illustrates the internal structure of the card processing apparatus of Fig. 1;

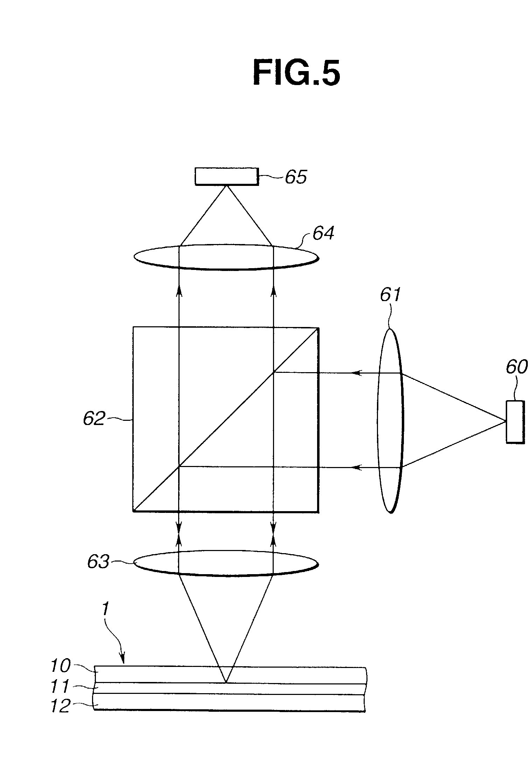

Fig. 5 illustrates a detail of the optical head shown in Fig. 4;
Fig. 6 is a flow chart for explaining the procedure of the departure examination utilizing an identification card system in accordance with an embodiment of the present invention; and
Fig. 7 is a flow chart for explaining the procedure of an immigration examination utilizing an identification card system in accordance with an embodiment of the present invention.

### EMBODIMENT OF THE INVENTION

An embodiment of the present invention will now be explained with reference to the drawings.

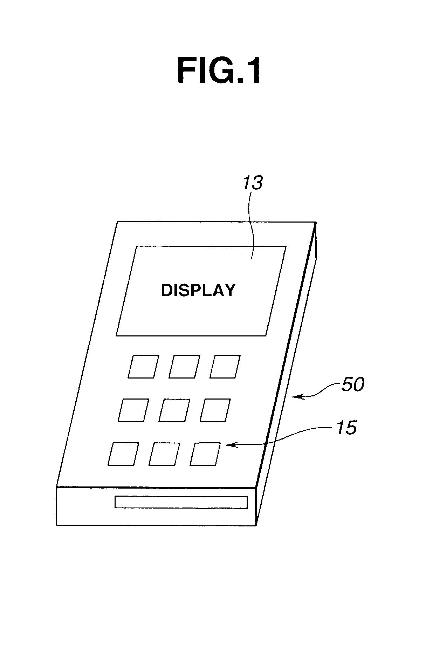

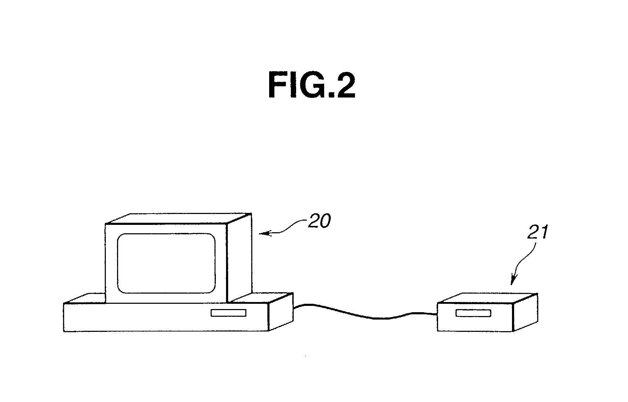

The identification card processing system of this embodiment includes a number of portable type identification card processing apparatus as shown in Fig. 1 located in a number of different passport control and immigration counters and a single host computer 20 and associated stationary type optical card information reading/writing apparatus 21 as shown in Fig. 2 set in a location remote from the passport and immigration counters.

Referring now particularly to Fig. 1, this figure illustrates the external appearance of one of the portable type identification card processing apparatus 50. The apparatus 50 is an optical card information reading/writing apparatus provided with a display 13 and a key panel 15 which can operate without connection to a host computer. Such a portable card processing apparatus is smaller than known stationary optical information reading and/or writing apparatus. The portable type card processing apparatus carries out recording of the information on an optical card and/or reproduction of the information from the optical card on the basis of the operation of the keys on the key panel 15.

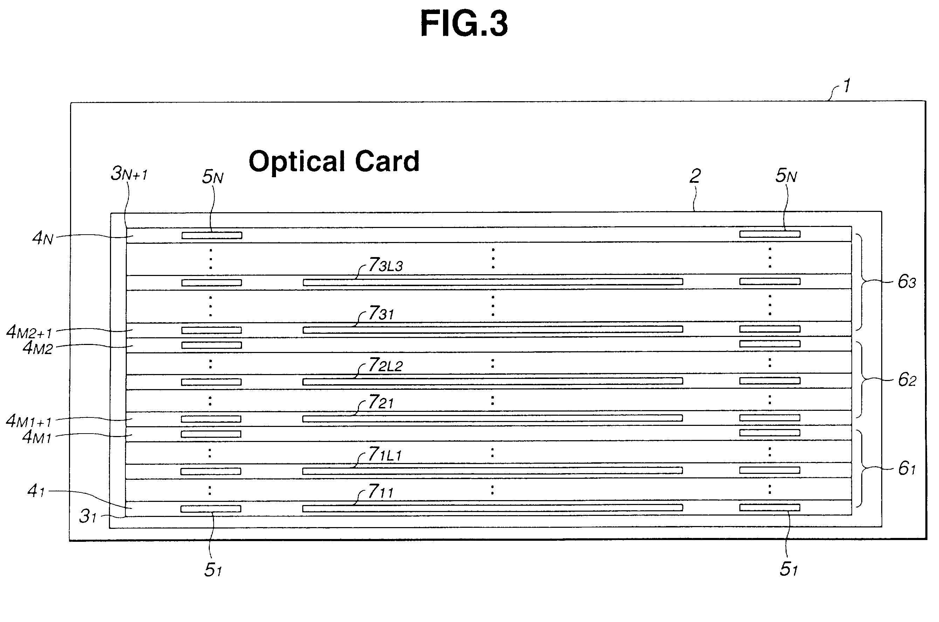

Fig. 3 illustrates one example of an optical card for use in the identification card processing system. In Fig. 3, an optical recording region 2 is arranged on the optical card 1. A number of straight tracking tracks 3₁-3_{N+1} are arranged in the optical recording region 2. Information tracks 4₁-4_{N} for recording the information are arranged between the tracking tracks. A physical track number 5₁-5_{N} for identifying each information track 4 is arranged at both ends of the information tracks 4. It is possible to divide the optical region 2 into a plurality of regions every few information tracks depending on the type of information recorded or to be recorded. In Fig. 3, the optical region 2 is divided into 3 blocks such that the information tracks 4₁-4_{M1} are in block 6₁, the information track 4_{M1+1}-4_{M2} are in block 6₂, and the information tracks 4_{M2+1}-4_{N} are in block 6₃. The information 7₁₁-7_{1L1} is recorded in block 6₁. The information 7₂₁-7_{2L2} is recorded in block 6₂. The information 7₃₁-7_{3L3} is recorded in block 6₃.

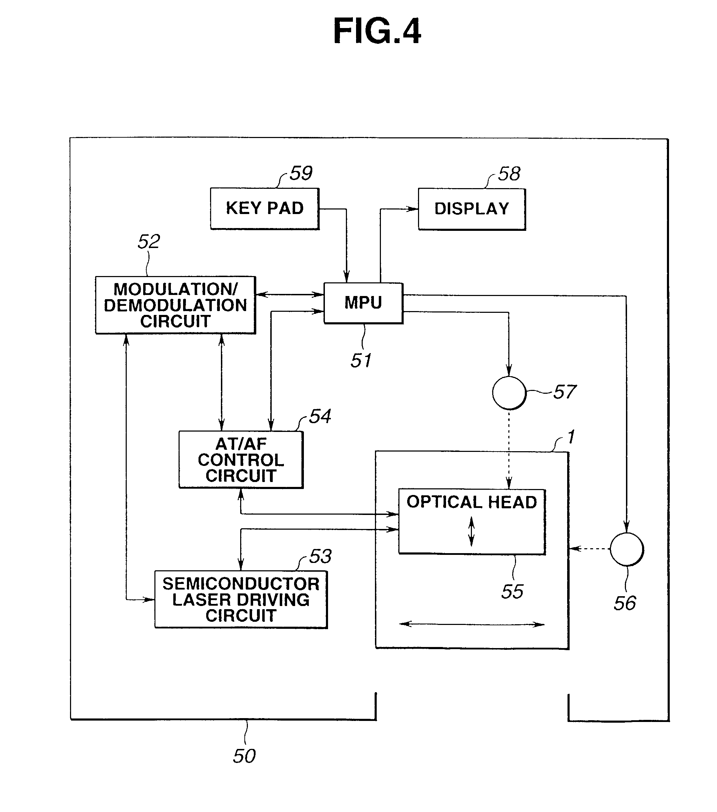

Fig. 4 illustrates the internal structure of the portable type card processing apparatus 50 shown in Fig. 1. The apparatus 50 includes an MPU 51 which controls each portion of the apparatus, a modulation and/or demodulation circuit 52 which modulates the recording information or demodulates the reproduced information, a semiconductor laser driving circuit 53 which drives a semiconductor laser light source (shown in Fig. 4), and an AT and AF control circuit 54 which controls auto tracking (AT) and auto focusing (AF). The apparatus 50 also includes an optical head 55 which in turn includes the semiconductor laser and optical system, a scanning motor 57 for moving the optical head 55 in the direction parallel to the information tracks 4₁-4_{N} on the optical card 1 and a seek motor 56 for moving the optical card in the direction orthogonal to the information track in order to access the light spot produced by the optical head 55 on a target track on the optical card of Fig. 3.

Fig. 4 illustrates a detail of the optical head 55, and also the physical structure of the recording card 1. The optical card 1 has the recording layer 11 formed on a support base 12 and a protective layer 10 formed on its surface. The laser beam emitted from the semiconductor laser 60 is shaped by a collimating lens 61, passes through a beam splitter 62, and then through an objective lens 63. The objective lens 63 condenses the light beam into a small spot on the recording layer 11 of the optical card 1. The light beam reflected from the optical card 1 passes back through the condenser lens 63, through the beam splitter 62, and through a condenser lens 64. The light beam passing through the condenser lens 64 is detected by an optical detector 65. The detected signal is sent to the AT/AF control circuit 54 in order to perform AT/AF control of the beam in a manner which will be well-known to those skilled in the art of optical reproducing apparatus. In this way it is possible to access a required track 4₁-4_{N} on the card 1.

In the portable type card reading/writing apparatus 50, the light spot accesses the target track on the card 1 by moving the optical card 1 in the direction orthogonal to the information track. In order for the light spot to access all tracks on the optical card 1, the size of the portable type card reading/writing apparatus 50 must enable the necessary movement of the optical card 1 within the apparatus. Therefore, the portable type card reading/writing apparatus 50 is limited in the range of information tracks which it is possible to access in order to avoid an increase in size of the apparatus. As a result, it is possible to reduce the size of the apparatus. In this apparatus 50, for example, although it is possible to access blocks 6₁ and 6₂ on the card 1, it is impossible to access block 6₃. As the portable type card reading/writing apparatus 50 is provided with a display 58 and keyboard 59, it is possible to reproduce information from the card and display the read out information on the display by operation of the keyboard 59.

As mentioned above, the system is also provided with a stationary type optical card processing apparatus 21 connected to a host computer 20 as shown in Fig. 2. This has nearly the same internal structure as the portable type card reading/writing apparatus 50, therefore, a detailed explanation is omitted. The stationary type card reading/writing apparatus does not itself have a display or keypad, but does have an interface for connection with the host computer 20 which is effective to give commands for performing recording and/or reproducing of the information. Using the stationary optical card information reading/writing apparatus 21 it is possible to access all the information tracks 4₁-4_{N} in the recording region 2 of the optical card 1.

In this particular embodiment, the identification card 1 is issued by the stationary optical card information reading/writing apparatus 21 of the type shown in Fig. 2, under the control of the host computer 20. Such a passport card is issued by a passport agency authorised by a government.

Information such as the identity of the passport issuer and the identity of the passport owner is recorded in block 6₁ on the optical card of Fig. 3. Also, information relating to the passport issuer including the name of the country issuing the passport card, the serial number, the date of issue, the expiry date, etc is recorded on the card in block 6₁. The passport owner information includes the name of the person who owns the passport card, their address, their date of birth, their sex, a picture of their face, whether there is any history of criminal acts, etc.

The apparatus, if there have been any criminal acts, records the details of these criminal acts in block 6₃ besides a series of information concerning the identity of the passport issuer and the identity of the passport owner.

Block 6₂ is used only when a passport owner departs from the country or enters into the country from abroad and is not recorded with any information when the passport card is issued. Although a portable type optical card processing apparatus is limited in the range of the information tracks which it can access, the identification card issuing apparatus can access all regions on the optical card and record information in block 6₃.

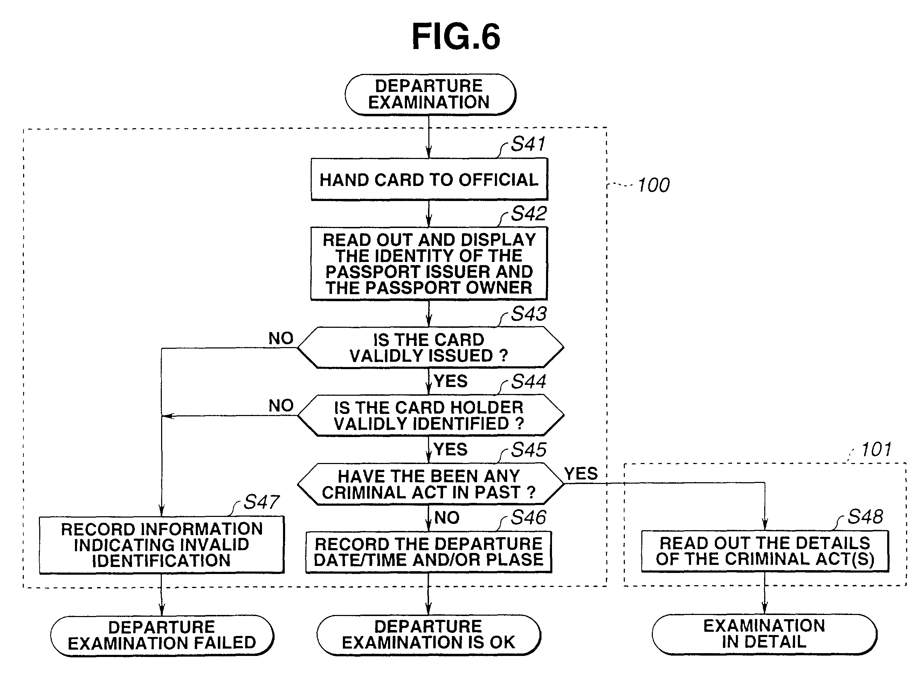

Fig. 6 is a flow chart for explaining the procedure of an examination on departure from a country utilizing an identification card system in accordance with the embodiment of the invention. In Fig. 6, the series of processes surrounded by a dotted line 100 in the flow chart are carried out by the portable type card processing apparatus 50 shown in Fig. 1. The process surrounded by the dotted line 101 in the flow chart is carried out by the stationary type card processing apparatus shown in Fig. 2.

Referring to Fig. 6, during the examination on departure, firstly a passport holder hands his passport card (ID card) to an official at passport control (S41). Next, the official inserts the ID card into a portable type card processing apparatus located in passport control. By operating the keyboard 59 on the apparatus, information such as the identity of the passport issuer and the identity of the passport owner recorded in block 6₁ on the card is readout and is displayed on the display 58 (S42).

Following this, the official judges whether there is a valid identification, by referring to the read out information such as the country name, the serial number, the issue date and time and the expiry date of the card (S43). Also, the official judges whether the card holder is the owner of the identification card or not, by referring to the read out information such as the name of the person, the address, the date of birth, sex, and picture of the card holder's face (S44). If, in either S43 or S44, the official judges that the identification is not valid, the information indicating an invalid card is recorded in block 6₂ of the card by operating the keyboard 59 (S47). In such a case, the card holder will be prevented from departing from the country because of the departure examination.

If, in either S43 or S44, the official judges the identification is valid, the official checks whether there have been any criminal acts in the past on the basis of the history of criminals act included on the card (S45). If there are no criminal acts recorded, the departure time/date and/or the place where this is confirmed is recorded in block 6₂ on the card (S46). After this, the card is returned to the card holder, the departure examination being completed.

Although the portable type apparatus 50 can not access block 6₃ on the card, it is possible to access block 6₁ and 6₂. Accordingly, this is enough to confirm the identification of the card issuer and the card owner.

On the other hand, in S45, where there is required a further detailed examination because criminal acts are recorded, the official takes the card to the place at which the stationary type processing apparatus is located. The details of the criminal act(s) recorded in block 6₃ are then reproduced using the stationary type processing apparatus (S48) to enable the official to examine the details.

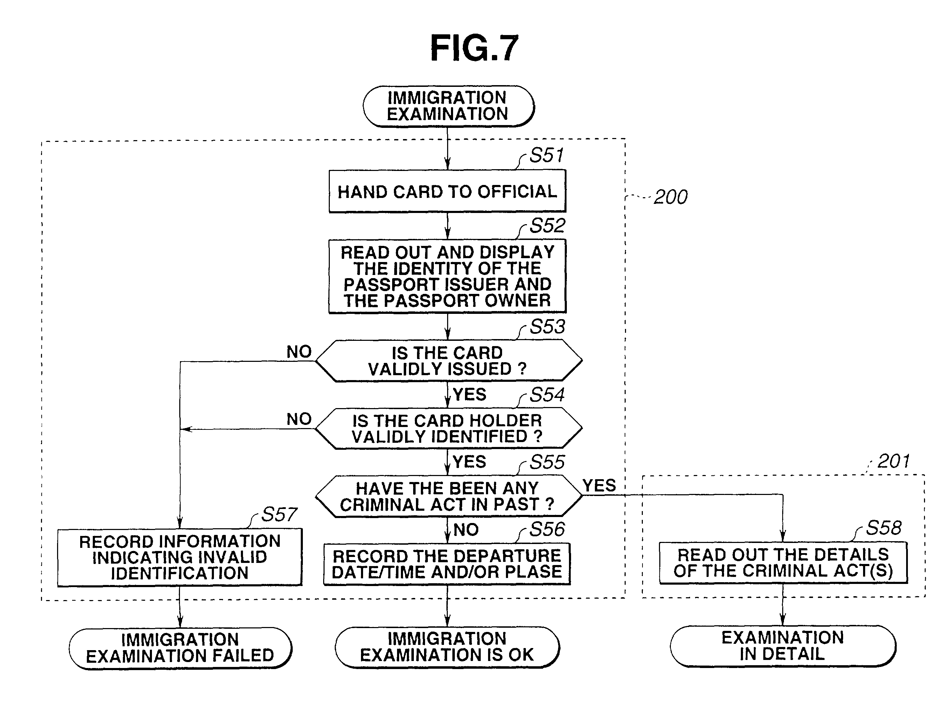

Fig. 7 is a flow chart for explaining the procedure of the immigration examination utilizing an identification card system in accordance with this embodiment of the invention. In Fig. 7, the series of processes surrounded by a dotted line 200 he flow chart are carried out by the portable type card processing apparatus 50 shown in Fig. 1. The process 201 surrounded by a dotted line 201 in the flow chart is carried out by the stationary type card processing apparatus as shown in Fig. 2.

In Fig. 7, when performing the immigration examination, firstly a passport holder hands his passport card to an official at an immigration counter (passport control) (S51). The official then inserts the card into a portable type card reading/writing apparatus located in passport control. By operating the keyboard 59, information such as the identity of the passport issuer and the identity of the passport owner is read out and is displayed on the display 58 (S52). It is possible to easily read out the information such as the identity of the passport issuer and the passport owner by the portable type card processing apparatus 50 because the information is recorded in the regions of the card from which it is possible to reproduce the information using the apparatus 50.

Following this, the official judges whether the card is validly issued, by referring to the information such as the country name, the serial number, the issue date and time, and the expiry date recorded on the card (S53). Also, the official judges whether the card is valid identification, by referring to the information such as the name of the person, the address, the date of birth, sex and picture of the face recorded on the card (S54). Further, the official checks whether any past criminal acts are recorded, by referring to the history of criminal acts. If the result of judgment is valid, the entry time/date and/or the place where this is confirmed is recorded on the ID card (S56). After that, the ID card is returned to the passport holder, and the immigration examination is complete.

On the other hand, if the result of the judgment is that the ID is invalid, information indicating an invalid ID card is recorded on the ID card by operating the keyboard 59 (S57). Also, if a further detailed examination is required because past criminal acts are recorded, the official takes the card to the stationary type card processing apparatus comprising the host computer 20 and the stationary type card reading/writing apparatus 21. The details of the criminal act are then reproduced from the card using the stationary type card reading/writing apparatus 21 (S58) and any necessary further investigation can be made by the official before allowing the card holder to pass passport control.

It will be appreciated that because the immigration examination and the departure examination will usually be carried out only using a portable type card processing apparatus 50, this apparatus does not occupy a large space in passport control. Also, the whole system is possible to install at a low cost since a number of portable type apparatus 50 as shown in Fig. 1 are provided whilst only one stationary type apparatus as shown in Fig. 2 is installed.

Although this particular embodiment explains the use of an identification card as a passport card, the present invention is not limited to this. In particular, it is possible to use such an identification card as a driver license card. Although the passport card includes the country name, the serial number, the issue date/time, the expiry date in the above embodiment, the present invention is not limited to systems arranged to read and write such information. In particular, the card may include other information such as the name of ID card issuing institution. Further, although the passport owner identification data includes the name of the person who owns the passport card, the address, the date of birth, sex, picture of the face, the history of criminal acts in the above embodiment, the present invention is limited to systems arranged to read and write such information. In particular, the card may include other information such as the telephone number of the person who owns the card.

It will also be appreciated that one or both of the portable and stationary type apparatus may be arranged only to read information recorded on the card and not to record information on the card.

It will also be appreciated that whilst an optical card is particularly appropriate for use in a system in accordance with the invention, the card may be, for example, a magnetically read card, a magneto-optic card, an IC card or a hybrid card including a combination of different recording media.

Whilst the present invention has been described with reference to what is presently considered to be the preferred embodiment, it is to be understood that the invention is not limited to the disclosed embodiment.

## Claims

1. An identification card system for confirming the validity of an identification card (1) by reading information recorded on the card comprising:
a first processing apparatus (20, 21) able to access all the information recording regions on the card (1); and
a second processing apparatus (50) able to access only part of the information recording regions on the card (1).

2. A system according to claim 1, wherein at least one of the first and second processing apparatus includes means for recording information in regions of the card which it is possible for said at least one processing apparatus to access.

3. A system according to any one of the preceding claims, wherein the first processing apparatus comprises a host computer (20) and a stationary type information reproducing apparatus (21).

4. A system according to any one of the preceding claims, wherein the second processing apparatus is a portable type information reproducing apparatus including a key panel (15) for initiating commands and a display (13).

5. A system according to any one of the preceding claims, wherein the second processing apparatus (50) is arranged to read information including the identity of the card issuer and the identity of the card holder from each card (1).

6. A system according to claim 2 or any claim dependent on claim 2, wherein said second apparatus (50) is arranged to record information relating to the time and/or place of reading the card (1).

7. A system according to claim 2 or any claim dependent on claim 2, wherein the second apparatus (50) is arranged to record information indicating an invalid card on the card (1) when the validity of the card is not confirmed.

8. A system according to any one of the preceding claims, wherein when there is doubt concerning the validity of the card, said first processing apparatus (20, 21) is arranged to read information recorded in the regions not accessible by the second processing apparatus (50).

9. An identification method for confirming the validity of an identification card by reading the information recorded on the card using a first processing apparatus (20, 21) able to access all the information recording regions on the card and a second processing apparatus (50) able to access part of the information recording regions on the card,
including the steps of:
reading information from the card using the second processing apparatus (50) to read information from regions accessible by the second apparatus (50); and
where it is necessary to obtain further information for confirming the validity of the card, reading information from further regions of the card using the first apparatus (20, 21).

10. A method according to claim 9, including the step of using the second apparatus (50) to record information on the regions of the card accessible by the second apparatus.
